(19) Europäisches Patentamt / European Patent Office / Office européen des brevets

(11) **EP 3 866 337 A1**

(12) **DEMANDE DE BREVET EUROPEEN**

(43) Date de publication:
**18.08.2021  Bulletin 2021/33**

(51) Int Cl.:
**H03F 1/02** (2006.01)     **H03F 3/217** (2006.01)
**H03F 3/30** (2006.01)

(21) Numéro de dépôt: **21165950.3**

(22) Date de dépôt: **25.07.2005**

(84) Etats contractants désignés:
**AT BE BG CH CY CZ DE DK EE ES FI FR GB GR HU IE IS IT LI LT LU LV MC NL PL PT RO SE SI SK TR**

(30) Priorité:  **30.07.2004  FR 0408473**

(62) Numéro(s) de document de la (des) demande(s) initiale(s) en application de l'article 76 CBE:
**20156218.8 / 3 691 122**
**05793315.2 / 1 771 944**

(71) Demandeur: **Devialet**
**75001 Paris (FR)**

(72) Inventeurs:
• **CALMEL, Pierre-Emmanuel, Marcel, Joseph**
**78000 Versailles (FR)**
• **ROBERT, Fabrice, Ange, Joseph**
**78180 Montigny-Le-Bretonneux (FR)**

(74) Mandataire: **Lavoix**
**2, place d'Estienne d'Orves**
**75441 Paris Cedex 09 (FR)**

Remarques:
Cette demande a été déposée le 30-03-2021 comme demande divisionnaire de la demande mentionnée sous le code INID 62.

(54)     **AMPLIFICATEUR AUDIO CLASSE AD**

(57)     L'amplificateur audio (10) comporte :
- un générateur de tension (18) comportant une source de tension et un transistor dont l'émetteur est connecté à la source de tension et le collecteur est relié à une tension par une résistance de mesure ;
- une source de courant (40) dont la sortie est connectée à la sortie du générateur de tension (18), et
- un étage (42) de commande de la source de courant (40) à partir du courant (ii) fourni par le générateur de tension (18) qui comporte des moyens (51) d'intégration dudit courant ($i_1$),
la source de tension étant pilotée pour que la tension entre une sortie (18B) et la masse soit représentative du signal à amplifier,
le transistor étant couplé à une source de courant PWM asservie par le courant du transistor et comportant un organe de commutation reliée par une inductance à la tension d'alimentation.

FIG.1

**Description**

La présente invention concerne un étage de sortie d'un amplificateur en tension, ainsi qu'un amplificateur audio.

La distorsion et le rendement sont des caractéristiques importantes pour un amplificateur audio.

Il est connu que la distorsion d'un amplificateur linaire en tension est relativement faible. Un amplificateur de ce type est dit de "classe A" ou "classe AB". Une telle structure est utilisée pour les amplificateurs de très haute gamme. Toutefois, le rendement de ces amplificateurs est mauvais, celui-ci étant de l'ordre de 25 à 70%.

A l'inverse, les amplificateurs de classe D ou à modulation par largeur d'impulsion (PWM) ont un très bon rendement. Ils sont formés d'amplificateurs dits numériques mettant en œuvre des éléments de commutation. Le rendement est compris entre 95 % et 98 %.

Ces amplificateurs sont peu linaires, puisqu'ils mettent en oeuvre des inductances et ont ainsi un taux de distorsion élevé conduisant à des performances audio médiocres.

Afin de chercher à combiner les avantages des deux types d'amplificateurs, à savoir obtenir un bon rendement et une faible distorsion, il est connu de coupler un amplificateur de classe A et un amplificateur de classe D pour former un amplificateur de classe AD.

Ainsi, un amplificateur en tension de faible impédance de sortie ayant un taux de distorsion faible est couplé avec un amplificateur en courant ayant un rendement élevé.

Une telle solution est décrite, par exemple, dans le document US 407 619. Ce brevet décrit le couplage d'un générateur de tension avec un générateur de courant, le générateur de courant fonctionnant en boucle ouverte et en dehors de la boucle de contre-réaction du générateur en tension.

Le générateur de courant est asservi à partir d'une mesure du courant total fourni par les deux générateurs, de manière à ce que le courant fourni par le générateur de courant soit 5 à 20 fois supérieur à celui fourni par le générateur de tension. Le couplage entre les deux générateurs est direct de manière à diminuer la distorsion du système.

La distorsion de l'amplificateur décrit est faible mais celui-ci n'a pas un rendement très élevé.

Ce rendement limité peut s'expliquer, notamment par le fait que le générateur de tension n'est pas de fort rendement pour obtenir une faible impédance de sortie ainsi que par la présence d'une résistance dans le circuit de retour à la masse de la charge qui introduit un déphasage du courant dès que la charge n'est pas purement résistive, ce qui est le cas d'un haut-parleur. Il en résulte une dégradation du facteur d'amortissement de l'amplificateur.

Comme le générateur de courant fonctionne en boucle ouverte, le gain est relativement imprécis, d'une part, et le déphasage de la mesure de courant implique un gain du générateur de courant significativement inférieur à 1 pour assurer une stabilité du système, d'autre part. La limitation du gain restreint le ratio de courant entre les deux générateurs à des valeurs comprises entre 5 et 20.

Enfin, la résistance de valeur assez élevée, placée en série avec le générateur de courant, dégrade fortement le rendement.

L'invention a donc pour but de proposer un étage de sortie d'un amplificateur en tension d'un amplificateur audio possédant à la fois une excellente linéarité, c'est-à-dire une faible distorsion, une impédance de sortie très basse, et un très bon rendement.

A cet effet, l'invention a pour objet un étage de sortie d'un amplificateur en tension selon la revendication 1.

Selon des modes particuliers de réalisation, l'étage de sortie comporte l'une ou plusieurs des caractéristiques des revendications dépendantes.

Enfin, l'invention a pour objet un amplificateur audio, selon la revendication 5.

Suivant des modes particuliers de réalisation, l'amplificateur audio comporte l'une ou plusieurs des caractéristiques des revendications dépendantes.

L'invention sera mieux comprise à la lecture de la description qui va suivre, donnée uniquement à titre d'exemple et faisant référence aux dessins sur lesquels :

- la figure 1 est une vue schématique du circuit de l'amplificateur selon l'invention ;
- la figure 2 est une vue à plus grande échelle de l'étage de sortie du générateur de tension selon l'invention mis en œuvre dans l'amplificateur de la figure 1.

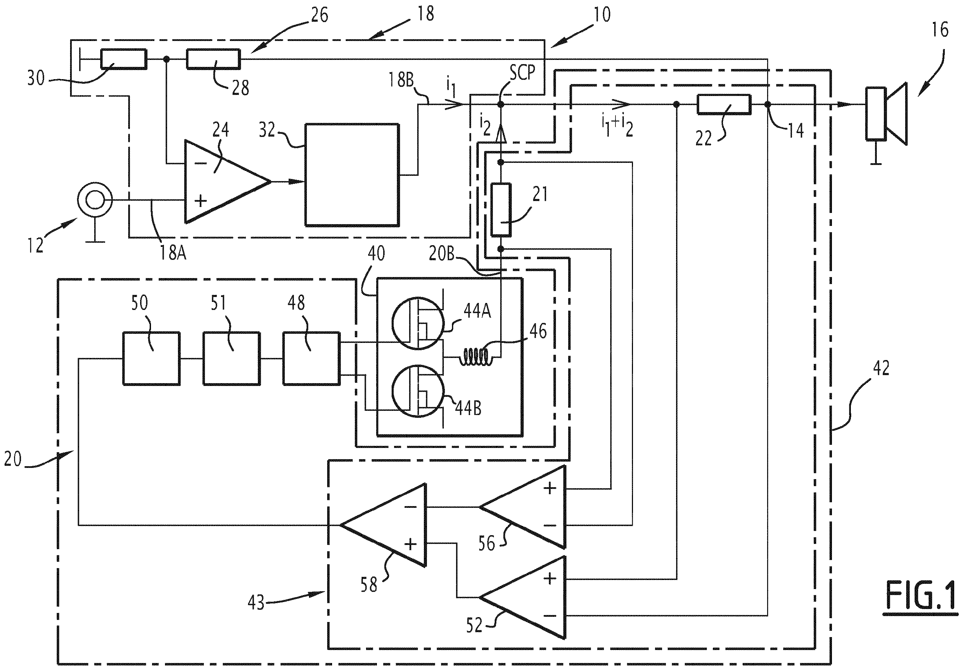

L'amplificateur audio 10 illustré sur la figure 1 comporte une entrée 12 pour la réception d'un signal audio à amplifier et une sortie 14 à laquelle est reliée une charge formée d'un haut-parleur 16. La charge 16 est reliée directement, sans autres éléments résistifs entre la sortie 14 de l'amplificateur et la masse.

L'entrée 12 de l'amplificateur est propre à recevoir une tension de commande dont la référence est la masse.

L'amplificateur est de classe AD. Ainsi, il comporte un générateur de tension 18 couplé à un générateur de courant 20. Ces générateurs fournissent respectivement un courant $i_1$ et $i_2$.

Le générateur de tension 18 présente une entrée 18A directement reliée à l'entrée 12 de l'amplificateur. La sortie notée 18B du générateur de tension est connectée à la sortie notée 20B du générateur de courant en un point de couplage noté SCP au travers d'une résistance 21 de mesure du courant $i_2$ fourni par le générateur de courant.

Les deux sorties 18B et 20B des générateurs de tension 18 et de courant 20 sont reliées à la sortie 14 de l'amplificateur seulement au travers d'une résistance 22 de mesure du courant total $i_1 + i_2$ de sortie de l'amplificateur. Les résistances 21 et 22 typiquement chacune de l'ordre de 0,1 Ohm sont intégrées dans une boucle de commande du générateur de courant 20, comme cela sera décrit dans la suite.

Le générateur de tension 18 comporte un étage d'amplification de tension 24 schématisé par un amplificateur différentiel dont l'entrée non inverseuse est reliée à l'entrée 18A et dont l'entrée inverseuse est reliée à une boucle de contre réaction 26 formée de deux résistances 28, 30 reliées en série entre la sortie 14 de l'amplificateur et la masse.

Ces deux résistances forment un pont diviseur de tension. La sortie inverseuse de l'amplificateur différentiel 24 est reliée au point milieu du pont diviseur de tension, c'est-à-dire entre les résistances 28 et 30.

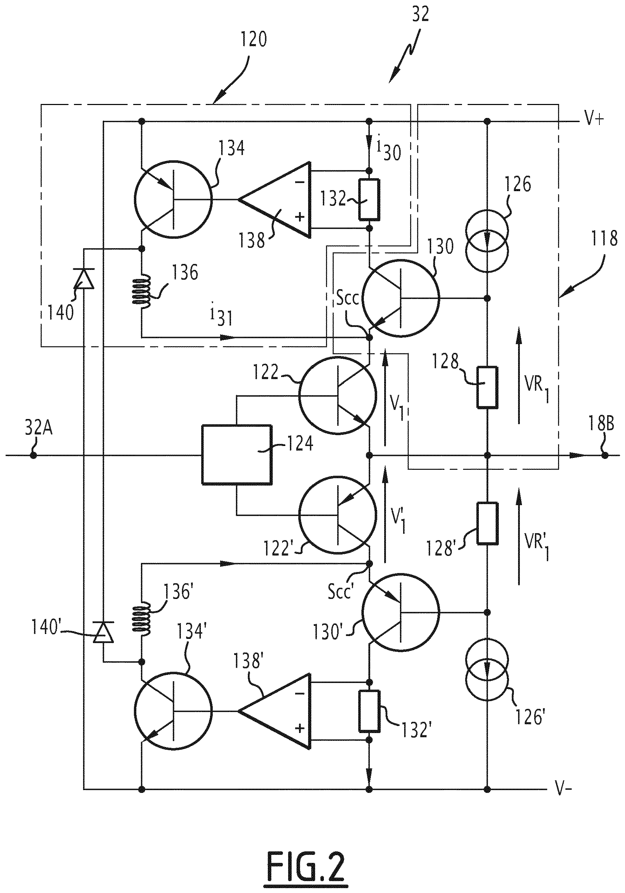

L'étage d'amplification de tension 24 est formé, par exemple, par une succession d'étages d'amplification. Entre l'étage d'amplification de puissance 24 et la sortie 18B est prévu un étage de sortie 32 de type cascode. Cet étage est représenté en détail sur la figure 2 et sera décrit ultérieurement.

L'impédance de sorte du générateur de tension 18 est très faible et, par exemple, de l'ordre de 0,025 Ohm. Elle est notamment inférieure à 0,20 Ohm. Le générateur de tension 18 possède une très bonne linéarité.

Le générateur de courant 20 est de type PWM, c'est-à-dire du type à modulation par largeur d'impulsion. Il présente un fort rendement.

Ce générateur de courant comporte essentiellement une source de courant 40 et une boucle 42 de commande de la source de courant. Cette boucle de commande 42 comporte des moyens 43 de mesure de l'intensité $i_1$ de sortie du générateur de tension 18.

La source de courant 40 comporte, comme connu en soi, deux transistors de puissance 44A, 44B formant des éléments de commutation de puissance alimentés depuis deux tensions opposées V+ et V-, et dont les sorties sont reliées ensemble à une borne d'une inductance 46 dont l'autre borne constitue la sortie 20B du générateur de courant.

Les grilles de commande des deux transistors 44A, 44B sont reliées à une unité de commande 48 intégrée à la boucle de commande 42. Cette boucle de commande comporte depuis la sortie des moyens 43 de mesure de l'intensité $i_1$ de sortie du générateur 18, des moyens de retard 50 du signal et des moyens d'intégration 51. Les moyens 51 peuvent être réalisés par l'inductance 46, dans certains cas.

Les moyens de mesure 43 comportent des moyens de mesure du courant total $i_1 + i_2$ de sortie de l'amplificateur et des moyens de mesure du courant $i_1$ fourni par le générateur de courant 20.

Plus précisément, les moyens de mesure de courant total $i_1 + i_2$ comportent la résistance 22 montée en série entre la sortie 14 de l'amplificateur et le point de couplage SC des deux générateurs. Ils comportent, en outre, un amplificateur différentiel 52 dont les deux entrées sont connectées aux bornes de la résistance 22.

Les moyens de mesure du courant $i_2$ de sortie du générateur de courant comportent la résistance 21 reliée en série entre la sortie de la source de courant 40 et la sortie 20B du générateur de courant, c'est-à-dire avant la connexion du générateur de courant au générateur de tension au point de couplage SCP. Un amplificateur différentiel 56 a ses entrées connectées aux bornes de la résistance 21 pour déterminer en sortie une information représentative du courant $i_2$ de sortie du générateur de courant 20.

Les sorties des amplificateurs différentiels 52 et 54 sont reliées aux deux entrées d'un amplificateur différentiel 58 propre à déterminer en sortie une information représentative du courant i1 fourni en sortie du générateur de tension 18.

L'étage de sortie 32 du générateur de tension 18 illustré sur la figure 2 est un montage symétrique alimenté depuis des tensions V+ et V- opposées, chaque moitié du montage étant propre à engendrer une tension d'un signe prédéfini.

Du fait de la symétrie du montage, seule la moitié supérieure du schéma sera décrite en détail, les éléments la constituant étant désignés par des numéros de référence, alors que les éléments correspondants de la partie inférieure du schéma sont désignés par les mêmes numéros de référence suivis du symbole "prime".

L'étage de sortie 32 est formé d'un générateur de tension 118 intégré à un montage de type cascode et une source de courant 120 couplée directement au générateur de tension. La source de courant 120 fonctionne en mode de largeur d'impulsions à fréquence variable asservie sur le courant $i_{30}$ traversant le générateur de tension 118, de manière à ce que ce courant reste constant.

En outre, l'étage de sortie 32 comporte un transistor 122 dont l'émetteur est relié directement à la sortie 18B de l'étage 32. La base du transistor 122 est reliée à une unité de pilotage 124 elle-même reliée à l'entrée notée 32A de l'étage de sortie. Cette unité de pilotage 124 est propre à recevoir le signal à amplifier et à piloter le transistor 122 pour que la tension entre l'émetteur de ce transistor et la masse soit représentative de la tension d'entrée 32A.

Suivant le montage cascode, le générateur de tension 118 comporte un générateur de courant 126 associé à une résistance 128 et à un transistor 130 fonctionnant en émetteur commun. Plus précisément, le transistor 130 a son émetteur connecté au collecteur du transistor 122 et son collecteur relié à la tension d'alimentation V+ au travers d'une résistance de mesure 132 du courant $i_{30}$ de la source de tension.

Le générateur de courant 126 est monté en série avec la résistance 128 entre la source d'alimentation V+ et la sortie 18B de l'étage de sortie. La base du transistor 130 est connectée entre la sortie du générateur de courant 126 et la résistance 128, la base du transistor 130 étant ainsi reliée à la sortie 18B au travers de la seule résistance 128. Le générateur de courant 126 est propre à fournir un courant constant au travers de la résistance R1.

Dans cet agencement, le transistor 130 forme un générateur de tension assurant avec la source de courant 120 qui lui est couplée une alimentation de la charge constituée du transistor 122.

La source de courant 120 comporte un transistor 134 dont l'émetteur est relié à la tension d'alimentation V+ et dont le collecteur est relié au collecteur du transistor 122 au travers d'une bobine 136. La base du transistor 134 est reliée à la sortie d'un comparateur à hystérésis 138 à deux seuils notés $V_a$ et $V_b$. Les deux entrées du comparateur 138 sont liées aux deux bornes de la résistance de mesure 132.

Enfin, une diode de roue libre 140 a sa cathode connectée entre le collecteur du transistor 134 et la bobine 136 et son anode connectée à la tension d'alimentation inverse V-.

Le fonctionnement de l'étage de sortie 32 va être décrit dans un premier temps puis, dans un second temps, le fonctionnement de l'amplificateur complet.

Dans le générateur de tension 118 intégré au montage cascode, la source de courant 126 engendre un courant constant au travers de la résistance 128. Ainsi, la tension notée $VR_1$ aux bornes de la résistance 128 est constante. Cette tension est appliquée à la base du transistor 130 qui fonctionne en émetteur commun.

La tension notée $V_1$, entre l'émetteur et le collecteur du transistor 122 est égale à la tension $VR_1$ constante aux bornes de la résistance diminuée de la tension également constante entre la base et l'émetteur du transistor 130. Ainsi, la tension $V_1$ est constante. Le transistor 122 fonctionne donc avec une tension collecteur-émetteur constante, de sorte que ses caractéristiques de gain et de capacité parasite collecteur-base sont constantes.

Pour la source de courant 120, la résistance 132 assure une mesure du courant notée $i_{30}$ qui circule dans les transistors 130 et 122. La tension aux bornes de la résistance 132 est directement proportionnelle au courant $i_{30}$ la traversant. Cette tension est comparée aux deux seuils $V_a$ et $V_b$ du comparateur à hystérésis 138.

Les seuils du comparateur à hystérésis sont tels que le courant efficace $i_{31}$ fourni par la source de courant 120 est au mois dix fois supérieur au courant efficace $i_{30}$ circulant dans le générateur de tension 130.

Quand la tension aux bornes de la résistance 132 dépasse le seuil haut $V_a$ fixé par le comparateur, le transistor 134 est passant. L'inductance 136 est soumise à une différence de potentiel égale à la tension d'alimentation V+ diminuée de la tension de sortie notée $V_{SCC}$. Ainsi, le courant noté $i_{31}$ circulant au travers de l'inductance 136, et fourni au point SCC entre les transistors 130 et 122, augmente avec une pente (V+ - $V_{SCC}$) divisée par $L_1$ où $L_1$ est la valeur de l'inductance 136. Le courant consommé par le transistor 122 restant constant, le courant $i_{30}$ traversant les transistors 130, 122 diminue jusqu'à atteindre le seuil bas $V_b$ du comparateur à hystérésis 138. Quand ce seuil bas $V_b$ est atteint, le transistor 134 est bloqué et l'inductance 136 continue à fournir le courant $i_{31}$ par l'intermédiaire de la diode de roue libre 140, le courant $i_{31}$ circulant au travers des transistors 122' et 130'. Le courant $i_{31}$ dans l'inductance 136 diminue au fur et à mesure que l'énergie stockée dans l'inductance est consommée.

Le courant $i_{30}$ augmente alors pour compenser la diminution du courant $i_{31}$ jusqu'à ce que le seuil haut $V_a$ soit atteint. Le processus décrit précédemment recommande alors.

Dans ces conditions, la source de courant 120 fonctionne en modulation de largeur d'impulsion à fréquence variable (PWM) asservie sur le courant traversant la résistance 132, de manière à ce que la valeur moyenne du courant $i_{30}$ reste constante.

Au nœud SCC, le générateur de tension 118 sous forme de montage cascode est couplé directement à la source de courant 120 de type PWM, de sorte que la majorité de l'énergie est fournie par la source de courant 120, sans perturber le fonctionnement du montage cascode.

La structure décrite ici pour l'étage de sortie 32 permet d'augmenter le courant de polarisation des transistors 122 et 122' sans impact significatif sur le rendement de l'amplificateur. En effet, la tension entre le collecteur et l'émetteur du transistor 122 ou 122' est constante et faible. Elle est typiquement de l'ordre de 3 volts.

Si, par exemple, la tension d'alimentation V+ est égale à 40 volts et l'intensité $i_{30}$ fournie par le générateur de tension 118 est égale à 10 mA alors que l'intensité $i_{31}$ fournie par la source de courant 120 est égale à 990 mA, avec un rendement de 95 % pour le générateur de courant 120, le courant de polarisation de 1 A conduit à une dissipation de seulement 3 x 1 = 3 W dans le transistor 122 et de 37 x 0,01 = 0,37 W dans le transistor 130 et 0,990 x 37 x (1 - 0,95) = 1,8 W dans le transistor 134 et la diode 140, soit un total d'environ 5 W.

Le montage cascode traditionnel, dépourvu de générateur de courant 120, dans les mêmes conditions de dissipation thermique aurait conduit à un courant de polarisation de 5/40 = 125 mA seulement, soit environ huit fois plus faible que le montage décrit ici.

L'augmentation du courant de polarisation pour une même dissipation thermique permet de diminuer de manière très importante l'impédance de sortie de l'amplificateur. Dans l'exemple précédent, l'impédance de sortie est de seulement 0,025 Ohm au lieu de 0,2 Ohm, soit une amélioration d'un facteur 8.

Concernant l'amplificateur audio dans sa globalité et tel qu'illustré sur la figure 1, le couplage direct au point de couplage SCP entre le générateur de tension 18 et la source de courant 20, sans qu'une résistance ne soit interposée entre le point de couplage et la source de tension, ou entre la masse et la charge, conduit à ce que la mesure du courant fourni par le générateur de tension puisse s'effectuer à partir de la mesure du courant total $i_1 + i_2$, laquelle mesure se fait à l'intérieur de la boucle de contre-réaction de la source de courant.

Dans l'amplificateur tel que décrit, le générateur de courant 20 fonctionne en boucle fermée, l'erreur étant déterminée par les moyens de mesure 43 avec un retour de gain unitaire. Les moyens de mesure 43 couplés à la fonction d'intégration mise en œuvre par les moyens 51 ou 46 conduisent à un gain en boucle ouverte infini pour le courant continu, et par conséquent à un gain en boucle fermée strictement unitaire à la fréquence nulle.

En conséquence, l'équation suivante est réalisée :

$$\dot{i}_z = \dot{i}_1 + \dot{i}_2 \ ;$$

$i_2 = i_z$

d'où l'on déduit que $i_1 = 0$.

Ainsi, la totalité du courant, et donc de la puissance, est fournie par le générateur de courant 20 de fort rendement tandis que le générateur de tension 18 impose uniquement la tension de sortie sans fournir aucun courant.

Ainsi, les ratios de courant peuvent atteindre plusieurs centaines avec la structure décrite ici et ce jusqu'à des fréquences de plusieurs dizaines de kHz.

En pratique, la source de tension 18 est réelle et donc imparfaite. Elle présente donc une impédance de sortie RV1 non nulle.

RV1 représente la résistance de sortie du générateur de tension ainsi que toute impédance parasite placée en série entre le générateur de tension et la source de courant.

Le générateur de tension est caractérisé par un gain Gv(p) et une résistance série RV1.

L'amplificateur différentiel 24 formé de l'étage 32 est caractérisé par un gain Ga1 (p), généralement du type passe-bas du premier ordre en pratique.

L'impédance $Z1 = \dfrac{V1}{I1}$ vaut en première approximation :

$$Z1 = \frac{RV1}{1 + Ga1(p).Gv(p).\dfrac{R2}{R1 + R2}}$$

et Z1 augmente avec la fréquence pour tendre vers RV1, car Ga1(p) et Gv(p) tendent vers 0 quand p augmente.

Toute distorsion de $i_2$ se traduit par un courant d'erreur qui se partage entre l'impédance Z de la charge 16 à savoir le haut-parleur et l'impédance du générateur de tension Z1.

Le courant $I_z$ dans la charge 16 vaut :

$$I_z = (\dot{i}_1 + \dot{i}_2)_{erreur} = \dot{i}_{2erreur} \times \frac{Z1}{Z1 + Z}$$

La réjection du courant d'erreur s'écrit donc

$$\nabla_{dB} = 20 \times \log\left(\frac{Z1 + Z}{Z1}\right)$$

et comme Z1<<Z

$$\nabla_{dB} \approx 20 \times \log\left(\frac{Z}{Z1}\right)$$

De plus,

$$\lim_{p\to\infty} \nabla_{dB} \approx 20 \times \log\left(\frac{Z}{RV1}\right)$$

Il est donc essentiel que l'amplificateur tension ait une impédance de sortie aussi faible que possible dans la bande audio, pour que l'amélioration du taux de distorsion, THD soit la plus élevée possible. Ceci impose qu'il n'y a pas de résistance série entre l'amplificateur tension et l'amplificateur courant d'une part et que l'amplificateur tension dispose d'une impédance de sortie en boucle ouverte très faible d'autre part.

Exemple :

Soit un haut-parleur d'impédance 8 ohm (Z=8 ohm) et

- un amplificateur traditionnel d'impédance de sortie 0.2 ohm en boucle ouverte
- un amplificateur utilisant la nouvelle structure d'étage de sortie, d'impédance 0.025 ohm

L'amélioration du taux de distorsion tend vers 20.log(8/0.2) = 32 dB dans le cas d'un amplificateur traditionnel et vers 20.log(8/0.025) = 50 dB dans le cas de l'amplificateur utilisant la nouvelle structure d'étage de sortie.

L'introduction d'une résistance de 1 ohm en série entre l'amplificateur tension et l'amplificateur courant dégraderait la réjection de la distorsion à une valeur 20.log(8/1.02) = 16 dB, causant des mauvais résultats en THD..

La source de courant 40, de type PWM de très fort rendement, fournit la totalité de l'énergie à la charge.

$\tau$ étant la valeur du retard 50, la fréquence d'oscillation de la source de courant 40 est fixée exclusivement par la plus petite des deux valeurs suivantes :

$$f_0 = \frac{1}{4.\tau}$$

$$\text{Arg}\left(\frac{1}{\frac{1}{Z(f1)}+\frac{1}{Z1(f1)}}\right) + \tau \times 2 \times \pi \times f1 = \frac{\pi}{2}.$$

$f_1$ telle que

Grâce à la nouvelle structure d'étage de sortie du générateur de tension ainsi qu'au couplage direct, Z1 est de module très faible, d'où $f_1$ est une fréquence élevée, supérieure à 5 Mhz. En pratique, c'est donc le retard $\tau$ qui fixe la fréquence de fonctionnement du système, de manière à ce qu'elle soit indépendante de la charge 16.

Comme la totalité de l'énergie fournie à la charge provient du générateur de courant, le rendement du système est déterminé majoritairement par celui de la source de courant. Les pertes du système ne sont constituées que :

- des pertes de commutations des transistors 44A,44B ;
- des pertes de polarisation de repos du générateur de tension, très fortement réduites pour une impédance de sortie donnée grâce à la nouvelle structure d'étage de sortie décrite figure 2 ;
- des pertes liées aux non linéarités de la source de courant à modulation par largeur d'impulsion.

L'amplificateur présente donc les caractéristiques suivantes :

- très fort rendement,
- très faible impédance de sortie,
- très bonne linéarité.

**Revendications**

1. Amplificateur audio (10) comportant :

   - une sortie (14) d'alimentation d'une charge (16) propre à assurer l'alimentation d'un haut-parleur électro-acoustique (16) ;
- un générateur de tension (18) de très haute linéarité et de faible impédance de sortie, le générateur comportant un étage de sortie (32) ;
- une source de courant (40) dont la sortie est connectée à la sortie du générateur de tension (18) en un point de couplage (SCP) relié à la sortie (14) d'alimentation de la charge (16), et
- un étage (42) de commande de la source de courant (40) à partir du courant (ii) fourni par le générateur de tension (18), l'étage (42) de commande de la source de courant (40) comportant des moyens (43) de mesure du courant ($i_1$) fourni par le générateur de tension (18),

l'étage (42) de commande de la source de courant (40) comportant des moyens (51) d'intégration dudit courant ($i_1$) mesuré fourni par le générateur de tension (18), les moyens (43) de mesure du courant ($i_1$) fourni par le générateur de tension (18) couplés à la fonction d'intégration mise en œuvre par les moyens d'intégration (51) conduisant à un gain en boucle ouverte infini en courant continu,

l'étage de sortie (32) comportant une entrée (32A) pour une tension d'entrée du signal à amplifier et une sortie (18B),

l'étage de sortie (32) comportant une première source de tension (122) connectée à la sortie (18B) et un transistor (130) formant un générateur de tension dont l'émetteur est connecté à la première source de tension (122) et le collecteur est relié à une tension d'alimentation (V+) au travers d'une résistance (132) de mesure du courant ($i_{30}$) du générateur de tension formé du transistor (130),

la première source de tension (122) étant reliée à une unité de pilotage (124) propre à recevoir la tension d'entrée du signal à amplifier (32A) et à piloter la première source de tension (122) pour que la tension entre la sortie (18B) et la masse soit représentative de la tension d'entrée du signal à amplifier (32A),

le transistor (130), formant un générateur de tension, étant couplé à une source de courant (120) fonctionnant en modulation de largeur d'impulsion et comportant un organe de commutation (134) reliée à la tension d'alimentation (V+) et relié en série avec une inductance (136),

la source de courant (120) fonctionnant en modulation de largeur d'impulsion étant asservie par le courant ($i_{30}$) traversant la résistance de mesure (132).

2. Amplificateur audio (10) selon la revendication 1, **caractérisé en ce que** la source de courant (120) fournit un courant efficace ($i_{31}$) au moins 10 fois supérieur au courant efficace ($i_{30}$) circulant dans le transistor (130) formant un générateur de tension.

3. Amplificateur audio (10) selon l'une quelconque des revendications précédentes, **caractérisé en ce que** la source de courant (120) fonctionnant en modulation de largeur d'impulsion fonctionne à fréquence variable.

4. Amplificateur audio (10) selon l'une quelconque des revendications précédentes, **caractérisé en ce que** la sortie de la source de courant (120) fonctionnant en modulation de largeur d'impulsion est reliée entre le transistor (130) et la sortie (18B) de l'étage de sortie (32), la tension (V1) entre l'émetteur du transistor (130) et la sortie (18B) de l'étage de sortie (32) étant constante.

5. Amplificateur audio (10) selon l'une quelconque des revendications précédentes, **caractérisé en ce que** la sortie du générateur de tension (18) est reliée directement au point de couplage (SCP) sans interposition d'élément résistif entre eux.

6. Amplificateur audio (10) selon l'une quelconque des revendications précédentes, **caractérisé en ce que** les moyens (43) de mesure du courant ($i_1$) fourni par le générateur de tension (18) sont disposés exclusivement en amont de la sortie (14) d'alimentation de la charge (16).

7. Amplificateur audio (10) selon l'une quelconque des revendications précédentes, **caractérisé en ce que** la source de courant (40) comporte deux transistors (44A, 44B) dont les sorties sont reliées ensemble à une borne d'une inductance (46) dont l'autre borne constitue la sortie (20B) de la source de courant, l'étage de commande (42) formant une boucle de commande intégrant une unité de commande (42) à laquelle les grilles de commande des deux transistors (44A, 44B) sont reliées.

8. Amplificateur audio (10) selon l'une quelconque des revendications précédentes, **caractérisé en ce que** des moyens (51) d'intégration dudit courant ($i_1$) mesuré fourni par le générateur de tension (18) sont propres à assurer une intégration uniquement dudit courant ($i_1$) mesuré fourni par le générateur de tension (18).

9. Amplificateur audio (10) selon l'une quelconque des revendications précédentes, **caractérisé en ce que** les moyens (43) de mesure du courant ($i_1$) fourni par le générateur de tension (18) couplés à la fonction d'intégration mise en œuvre par les moyens d'intégration (51) conduisent à un gain en boucle ouverte infini en courant continu de la fonction de transfert définie par le quotient du courant ($i_2$) de sortie du générateur de courant (40) divisé par le courant ($i_1$) fourni en sortie de l'étage de sortie (32) du générateur de tension (18).

10. Amplificateur audio (10) selon l'une quelconque des revendications précédentes, **caractérisé en ce que** la base du transistor (130) est maintenue à un potentiel constant (VR1) par rapport à la tension de la sortie (18B), de sorte que la tension (V1) aux bornes de la première source de tension (122) est constante.

11. Amplificateur audio (10) selon l'une quelconque des revendications précédentes, **caractérisé en ce que** l'impédance de sortie du générateur de tension (18) est inférieure à 0,2 ohms.

12. Amplificateur audio (10) selon l'une quelconque des revendications précédentes, **caractérisé en ce que** l'étage de commande (42) de la source de courant (40) comporte des moyens (50) de retard du signal de commande.

13. Amplificateur audio (10) selon l'une quelconque des revendications précédentes, **caractérisé en ce que** la source de courant (120) fonctionnant en modulation de largeur d'impulsion comporte un comparateur à hystérésis (138) dont les entrées sont connectées aux bornes de la résistance de mesure (132), l'organe de commutation (134) étant commandé par la sortie du comparateur à hystérésis (138), une diode de roue libre (140) reliant une tension d'alimentation (V-) au point de connexion entre l'organe de commutation (134) et l'inductance (136).

14. Amplificateur audio (10) selon l'une quelconque des revendications précédentes, **caractérisé en ce qu'**il comporte une seconde source de tension (126, 128) propre à maintenir constante la tension entre la base du transistor (130) et la sortie (18B) de l'étage de sortie (32), la seconde source de tension comportant un générateur de courant (126) monté en série avec une résistance (128).

**FIG.1**

EP 3 866 337 A1

FIG.2

Europäisches
Patentamt

European
Patent Office

Office européen
des brevets

# RAPPORT DE RECHERCHE EUROPEENNE

Numéro de la demande

EP 21 16 5950

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | EP 0 962 120 A1 (KOREA ADVANCED INST SCI & TECH [KR]) 8 décembre 1999 (1999-12-08)<br>* abrégé *<br>* figures 2-3 *<br>* alinéa [0018] - alinéa [0025] *<br>* alinéa [0036] - alinéa [0074] *<br>----- | 1-14 | INV.<br>H03F1/02<br>H03F3/217<br>H03F3/30 |
| Y | JP H05 63453 A (YAMAHA CORP) 12 mars 1993 (1993-03-12)<br>* abrégé *<br>* alinéa [0003] - alinéa [0039] *<br>* * les références à ce document sont celles de la traduction automatique *<br>* figures 2-3,4-5 *<br>----- | 1-14 | |
| Y | EP 0 519 471 A1 (YAMAHA CORP [JP]) 23 décembre 1992 (1992-12-23)<br>* abrégé *<br>* colonne 4, ligne 57 - colonne 11, ligne 13 *<br>* figures 1,9,10,11,14,15 *<br>----- | 1-14 | |
| Y | JP H05 67925 A (YAMAHA CORP) 19 mars 1993 (1993-03-19)<br>* abrégé *<br>* figures 4-5 *<br>* alinéas [0030] - [0040] *<br>* * les références à ce document sont celles de la traduction automatique *<br>----- | 1-14 | DOMAINES TECHNIQUES RECHERCHES (IPC)<br><br>H03F |

-/--

Le présent rapport a été établi pour toutes les revendications

| Lieu de la recherche | Date d'achèvement de la recherche | Examinateur |
|---|---|---|
| La Haye | 4 juillet 2021 | Mouanda, Thierry |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 21 16 5950

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | RONAN A R VAN DER ZEE ET AL: "A Power-Efficient Audio Amplifier Combining Switching and Linear Techniques", IEEE JOURNAL OF SOLID-STATE CIRCUITS, IEEE, USA, vol. 34, no. 7, 1 juillet 1999 (1999-07-01), XP011061045, ISSN: 0018-9200 * abrégé * * figure 4 * * III. THE CIRCUIT PRINCIPLE * ----- | 1-14 | |
| Y | US 2001/030577 A1 (STEPHENS RANDALL J [US] ET AL) 18 octobre 2001 (2001-10-18) * abrégé * * alinéas [0016] - [0030] * ----- | 1-14 | |
| A | US 5 710 522 A (PASS NELSON S [US]) 20 janvier 1998 (1998-01-20) * abrégé * * figure 4B * * figure 2 * * colonne 1, ligne 58 - colonne 2, ligne 14 * * colonne 2, ligne 32 - colonne 5, ligne 63 * ----- | 1-12 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| La Haye | 4 juillet 2021 | Mouanda, Thierry |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

page 2 de 2

## ANNEXE AU RAPPORT DE RECHERCHE EUROPEENNE
### RELATIF A LA DEMANDE DE BREVET EUROPEEN NO.

EP 21 16 5950

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-07-2021

| Document brevet cité au rapport de recherche | Date de publication | Membre(s) de la famille de brevet(s) | Date de publication |
|---|---|---|---|
| EP 0962120 A1 | 08-12-1999 | AU 6122298 A | 09-09-1998 |
| | | CN 1217864 A | 26-05-1999 |
| | | DE 69822135 T2 | 03-03-2005 |
| | | EP 0962120 A1 | 08-12-1999 |
| | | JP H10242779 A | 11-09-1998 |
| | | KR 19980068755 A | 26-10-1998 |
| | | US 6396933 B1 | 28-05-2002 |
| | | WO 9837731 A1 | 27-08-1998 |
| JP H0563453 A | 12-03-1993 | JP 3092244 B2 | 25-09-2000 |
| | | JP H0563453 A | 12-03-1993 |
| EP 0519471 A1 | 23-12-1992 | DE 69224409 T2 | 17-09-1998 |
| | | EP 0519471 A1 | 23-12-1992 |
| | | JP 2669199 B2 | 27-10-1997 |
| | | JP H04372212 A | 25-12-1992 |
| | | US 5347230 A | 13-09-1994 |
| JP H0567925 A | 19-03-1993 | AUCUN | |
| US 2001030577 A1 | 18-10-2001 | US 2001030577 A1 | 18-10-2001 |
| | | US 2005068104 A1 | 31-03-2005 |
| US 5710522 A | 20-01-1998 | AUCUN | |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 407619 A